# EUROPEAN PATENT SPECIFICATION

(11) **EP 0 340 959 B1**
(45) Date of publication and mention of the grant of the patent: **28.12.1994**
(21) Application number: 89304081.6
(22) Date of filing: 24.04.1989
(51) Int. Cl.: H01L 23/043, H01L 23/10, H01L 23/40

(54) **Package for EMI, ESD, thermal, and mechanical shock protection of circuit chips**
Schaltungschipspackung zum Schützen gegen elektromagnetische Interferenzen, elektrostatische Entladungen und thermische und mechanische Spannungen
Empaquetage pour la protection de puces à circuit contre des interférences électromagnétiques, des décharges électrostatiques et des chocs thermiques et mécaniques

(30) Priority: 06.05.1988 US 190823
(43) Date of publication of application: 08.11.1989
(73) Proprietor: DIGITAL EQUIPMENT CORPORATION, Maynard, MA 01754-1418 (US)
(72) Inventor: Barker III, Charles R., Harvard Massachusetts 01451 (US); Casabona, Richard J., Stow Massachusetts 01775 (US); Fenwick, David M., Chelsford Massachusetts 01824 (US)
(74) Representative: Goodman, Christopher

(56) References cited:
- EP-A- 0 103 068
- DE-A- 2 749 848
- US-A- 3 303 392
- IBM TECHNICAL DISCLOSURE BULLETIN, vol. 30, no. 10, March 1988, pages 310-311,Armonk, New York, US; "Thermal enhancement and mechanical protection cover"
- IBM TECHNICAL DISCLOSURE BULLETIN, vol. 9, no. 277 (E-355)[2000], 6th November1985; & JP-A-60 120 541
- PATENT ABSTRACTS OF JAPAN, vol. 9, no. 258 (E-350)[1981], 16th October 1985;& JP-A-60 106 150

## Description

### BACKGROUND OF INVENTION

The present invention relates, in general, to a package for circuit chips which provides integral protection of the chips from electromagnetic interference (EMI), electrostatic discharge (ESD), temperature extremes, and, mechanical shock. The package also shields the environment from EMI emissions from the chips.

Modern integrated circuit technology, such as CMOS and ECL, utilize integrated circuit packages that include ICs with high lead count, relatively fragile interconnects, high power dissipation, and fast switching speeds. In order to operate properly and reliably, these circuits must be protected from extreme operating temperatures, mechanical shock, electromagnetic interference, and electrostatic discharge. Also, the FCC imposes requirements with respect to EMI emissions from devices such as these, and shielding must threfore be provided to protect the environment from these emissions.

In the past, various attempts have been made to provide solutions to each of the above issues individually, but not in combination with one another. For example, heat sinks have long been used for electronics packaging to maintain the temperature of the electronics within their operating range. However, these do not provide shock, EMI, or ESD protection. Similarly, module shielding techniques, such as can found in a TV, VCR, or video decoder, for example, employ a metal "can" that is formed around a series of components, and is connected to provide EMI shielding for the components, but no thermal or mechanical shock protection for the same.

In IBM Technical Disclosure Bulletin, Vol 30, No 10, March 1988, pp310-311, there is shown a mechanical protection cover for electrical devices incorporating enhanced thermal dissipation, including a metallic cover bonded to a base upon which a device is mounted. Thermal and mechanical connection is made between the cover and the upper surface of the device using an adhesive.

DE-2749848 discloses a similar arrangement having a thermally conductive material contained within a film bonded to the lower side of a heat-dissipative cover, which is placed in contact with the upper surface of an enclosed device.

JP-60120541 discloses an electrostatic damage protection layer on a circuit package comprising a metallic conductive layer on the outer surface thereof.

### SUMMARY OF THE INVENTION

It is therefore the object of the present invention to provide an integral package for integrated circuits which will protect the circuits from extreme temperatures, mechanical shock, EMI, and, ESD, and also, shield the environment from EMI emissions from the circuits.

This, and other objects of the invention, are attained through provision of the package of claim 1. This package may include a printed wiring board base for reception of one or more circuit chips, and a five sided box type cover and heat sink having integral heat radiating fins formed in the top thereof. To provide mechanical shock protection for the circuit chips, compliant stand off supports are employed between the chips and the base to support the chips on the base. A thermally conductive elastomer, or other spring material, can then be placed on top of each circuit chip so that when the heat sink cover is secured to the base, the inner top surface of the cover will contact the elastomer, and compress both the elastomer on the top of each chip, as well as the compliant supports below each chip. As a result, each chip is held securely and is protected from mechanical shocks to which the package is subjected. Also, the thermally conductive elastomer provides an excellent thermal path between each of the chips, and the heat sink, to thereby insure adequate control of the chip operating temperatures

To provide an EMI shield between each chip and the environment, the heat sink is made of a conductive material, such as aluminum, and is electrically connected to a reference plane in the printed wiring board base. Each chip is thus surrounded by the conductive shield formed by the heat sink, and the reference plane.

For ESD protection, an additional conductive coating is necessary. This is provided by applying an insulating material to the outside surface of the heat sink, and then applying an additional conductive coating on top of the layer of insulating material. This conductive coating is electrically connected to the heat sink, and to the wiring board reference plane by a conductive gasket, or contact, that is disposed in the heat sink/base interface when the package is assembled.

### BRIEF DESCRIPTION OF THE DRAWINGS

The foregoing and additional objects, features, and advantages, of the invention will become apparent from the following detailed description thereof, taken in conjunction with the accompanying drawings, in which:
FIG. 1 is a diagrammatic perspective view of a circuit package constructed in accordance with the present invention showing a combination heat sink and cover removed; and,
FIG. 2 is a partial cross sectional view showing the details of the circuit package.

### DETAILED DESCRIPTION OF THE PREFERRED EMBODIMENT

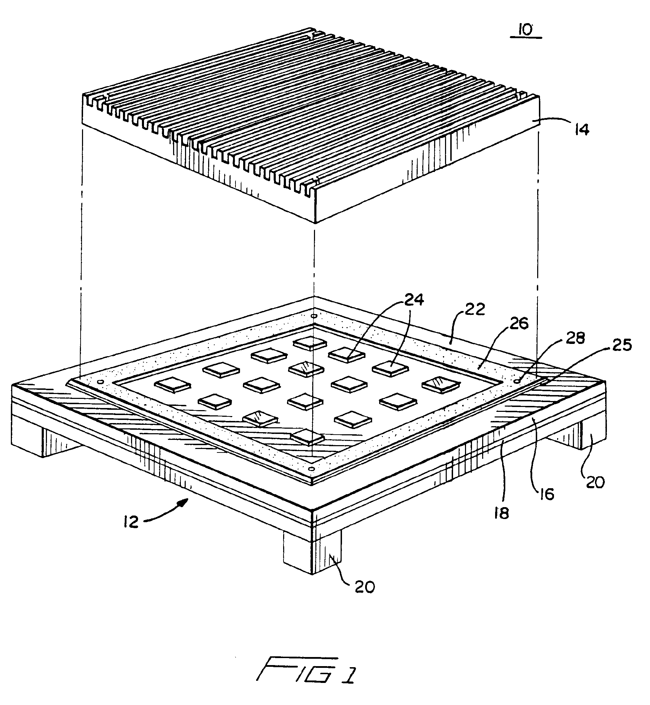

Turning now to a more detailed consideration of the invention, there is illustrated in FIG. 1, an integrated circuit package 10, which includes a base 12, and a combination heat sink and cover 14.

Base 12 is preferably formed from a printed wiring board 16, which is a layered substrate having a conductive layer 18 disposed in the middle thereof that forms a "reference plane". A plurality of support pads or blocks 20 can be disposed beneath the four corners of board 16, if desired.

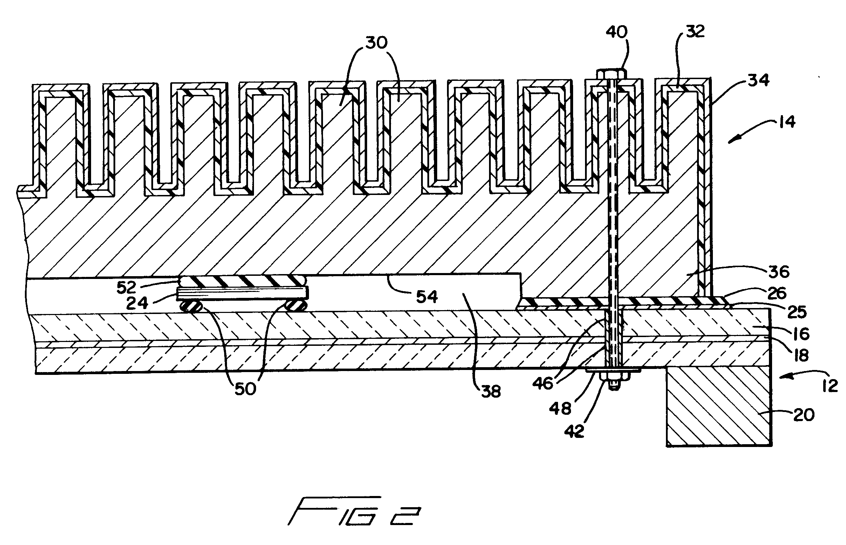

Disposed on a top surface 22 of board 16, are one or more integrated circuit chips, or other electrical devices, 24. It will be understood that package 10 can be sized to accommodate any number or size of chips or devices. Further details of the chip mountings are illustrated in FIG. 2, and it will be understood that each of the chips includes a plurality of conductor leads (not shown) for electrically connecting them to circuitry in printed wiring board 16.

Also disposed on top surface 22, and generally around its periphery, is a narrow rectangular frame shaped conductive metal strip 25, on top of which is disposed, a similar shaped strip of conductive material 26, which surrounds the mounting area for chips 24. Conductive material 26 is preferably compliant, and can be a spring metal, or conductive elastomer, for example. This acts as an electrical gasket for the interface between heat sink 14 and base 12, and will be discussed in further detail below. A plurality of apertures 28 are disposed in compliant strip 26 at its corners that also pass through board 16 to receive mounting screws or bolts for attaching heat sink 14 to base 12.

Turning now to FIG. 2, package 10 is shown in greater detail. As illustrated, heat sink 14, which is constructed of a conductive material such as aluminum, preferably includes a plurality of heat radiating fins 30. It should be understood that other types of radiating elements could be formed on heat sink 14 if desired, or if liquid cooling is employed, no heating radiating elements at all are necessary. Disposed on all exterior surfaces of heat sink 14, including fins 30, is a first layer or coating 32 of electrical insulating material. A second layer or coating 34 is placed over insulating layer 32, and is formed from any suitable type of conductive material. Conductive layer 34 provides a surface separate from heat sink 14 for the accumulation of static charge, and thereby provides protection of chips 24 from electrostatic discharges.

When heat sink 14 is assembled to base 12, an integral depending peripheral rim or flange 36 of heat sink 14 engages compliant conductive strip 26, and forms a sealed area 38 for chips 24. A plurality (one shown) of bolts or screws 40, and corresponding nuts 42 are employed for securing heat sink 14 to base 12.

Conductive metal strip 25 is formed integrally with a plurality of conductive vias 46 that pass through apertures 28 in base 12. Vias 46 electrically contact reference plane conductive layer 18, and further extend to the bottom surface of wiring board 16, where small conductive areas 48 are formed for electrically contacting nuts 42.

Compliant conductive layer 26 and metal strip 25 serve to electrically connect heat sink 14, conductive coating 34, and reference plane 18 to thereby provide an enclosure for chips 24, which is shielded both from electromagnetic interference, and from electrostatic discharge. Conversely, the exterior environment is shielded from EMI emissions from the chips 24. In addition, the compliant nature of layer 26, helps insure that chip area 38 will be sealed from external dirt, moisture, etc.

Chips 24 are preferably supported on wiring board 16 by a plurality of compliant pads or cushions 50 which are placed on top surface 22 beneath each of the chips. A thermally conductive compliant cushion 52 is preferably disposed on top of each chip 24, and engages an inner top surface 54 of heat sink 14 when the same is secured to base 12. Cushion 52 not only insures that good thermal contact will be made between chips 24 and heat sink 14, but also insures, in conjunction with support pads 50, that chips 24 will be held securely in position, and insulated from mechanical shock. Alternatively, cushion 52 can be eliminated if desired, and the heat sink dimensions adjusted so that inner top surface 54 will directly contact chips 24 when heat sink 14 is in position.

From the foregoing, it may be thus seen that package 10 is constructed in a simple and compact manner, and provides excellent mechanical, thermal, and electrical protection for chips 24. Heat sink 14 acts to draw heat away from the chips, to hold the chips securely but compliantly in position, and to provide a sealed enclosure for the chips as well. In addition, because it is made of electrically conductive material, heat sink 14, in conjunction with reference plane conductive layer 18, also acts as an EMI shield for chips 24, and in conjunction with conductive coating 34, acts as an ESD shield for chips 24.

## Claims

1. A package (10) for an electrical device (24) comprising:
a base member (12) having an electrically conductive layer (18) disposed therein;
a strip of an electrically conductive material (25,26) disposed on an upper surface (22) of said base about the periphery of said base and enclosing a portion of the upper surface of said base;
an electrically conductive heat sink cover member (14) disposed on said electrically conductive strip (25,26) and electrically connected to said strip of electrically conductive material and said electrically conductive layer (18) to form an electromagnetic interference shielded enclosure;
an electrical device disposed within said interference shielded enclosure;
means (50,52), disposed in said shielded enclosure, for compliantly and securely holding said electrical device in position within said shielded enclosure between said base and heat sink cover members and in thermal contact with said heat sink cover member (14) for directing heat away from said electrical device, comprising at least a first compliant pad (50) disposed between said base member (12) and said electrical device; and
an insulating layer of material (32) disposed on an exterior surface of said heat sink cover member (14), and a further layer of electrically conductive material (34) disposed over said insulating layer (32) and electrically connected to said electrically conductive layer (18) and said strip (25,26) of said base member (12) for shielding said electrical device from electrostatic discharge.

2. The package of claim 1, wherein heat radiating means (30) are provided on said heat sink cover member (14).

3. The package of claim 4 further including at least a second compliant pad of thermally conductive material (52) disposed between an inner top surface (54) of said cover member (14) and said electrical device (24).

4. The package of claim 1, wherein
said insulating layer of material (32) is disposed on all exterior surfaces of said heat sink cover member (14).

## Patentansprüche

1. Gehäuse (10) für ein elektrisches Bauelement (24), enthaltend:
ein Basisteil (12) mit einer darin angeordneten elektrisch leitenden Schicht (18);
einen Streifen aus einem elektrisch leitenden Material (25, 26), das auf einer Oberseite (22) der Basis rings um den Umfang der Basis angeordnet ist und einen Abschnitt der Oberseite der Basis umgibt;
ein elektrisch leiten des Kühlkörper-Abdeckungs-Teil (14), das auf dem elektrisch leitenden Streifen (25, 26) angeordnet und elektrisch mit dem Streifen aus elektrisch leitendem Material und der elektrisch leitenden Schicht (18) verbunden ist, um eine gegen Störstrahlungen abgeschirmte Hülle zu bilden;
ein elektrisches Bauelement, das innerhalb der gegen Störstrahlungen abgeschirmten Hülle angeordnet ist;
in der abgeschirmten Hülle angeordnete Mittel (50, 52) zum nachgiebigen und sicheren Festhalten des elektrischen Bauelements an seinem Platz innerhalb der abgeschirmten Hülle zwischen dem Basisteil und dem Kühlkörper-Abdeckungs-Teil und im Wärmekontakt mit dem Kühlkörper-Abdeckungs-Teil (14), um Wärme von dem elektrischen Bauelement abzuleiten, enthaltend wenigstens ein erstes nachgiebiges Polster (50), das zwischen dem Basisteil (12) und dem elektrischen Bauelement angeordnet ist; und
eine isolierende Schicht aus Material (32), das auf einer Außenseite des Kühlkörper-Abdeckungs-Teils (14) angeordnet ist, und eine weitere Schicht aus elektrisch leitendem Material (34), das auf der isolierenden Schicht (32) angeordnet und elektrisch mit der elektrisch leitenden Schicht (18)und dem Streifen (25, 26) des Basisteils (12) verbunden ist, um das elektrische Bauelement gegen elektrostatische Entladungen abzuschirmen.

2. Gehäuse nach Anspruch 1, wobei auf dem Kühlkörper-Abdeckungs-Teil (14) Wärmestrahlungsmittel (30) vorgesehen sind.

3. Gehäuse nach Anspruch 1, das weiterhin wenigstens ein zweites nachgiebiges Polster aus wärmeleitendem Material (52) enthält, das zwischen einer inneren Oberfläche (54) des Abdeckungs-Teils (14) und dem elektrischen Bauelement (24) angeordnet ist.

4. Gehäuse nach Anspruch 1, wobei die isolierende Materialschicht (32) auf allen Außenseiten des Kühlkörper-Abdeckungs-Teils (14) angeordnet ist.

## Revendications

1. Boîtier (10) pour un dispositif électrique (24), comprenant :
un élément formant base (12) comportant, disposée en lui, une couche conductrice d'électricité (18);
une bande (25, 26) faite d'un matériau conducteur d'électricité disposée sur une surface supérieure (22) de ladite base autour de la périphérie de cette dernière et enfermant une partie de la surface supérieure de ladite base;
un élément formant couvercle dissipateur de chaleur (14) conducteur d'électricité, disposé sur ladite bande conductrice d'électricité (25, 26) et relié électriquement à ladite bande de matériau conducteur d'électricité et à ladite couche conductrice d'électricité (18) pour former une enceinte protégée contre des interférences électromagnétiques;
un dispositif électrique disposé à l'intérieur de ladite enceinte protégée contre des interférences;
des moyens (50, 52) disposés dans ladite enceinte protégée pour maintenir d'une manière élastique et fixe ledit dispositif électrique en place à l'intérieur de ladite enceinte protégée, entre ledit élément formant base et ledit élément formant couvercle dissipateur de chaleur et en contact thermique avec ledit élément formant couvercle dissipateur de chaleur (14) pour diriger la chaleur à distance dudit dispositif électrique, comprenant au moins un premier rembourrage élastique (50) interposé entre ledit élément formant base (12) et ledit dispositif électrique; et
une couche isolante de matériau (32) disposée sur une surface extérieure dudit élément formant couvercle dissipateur de chaleur (14), et une couche supplémentaire de matériau conducteur d'électricité (34) disposée sur ladite couche isolante (32) et reliée électriquement à ladite couche conductrice d'électricité (18) et à ladite bande (25, 26) dudit élément formant base (12) pour protéger ledit dispositif électrique contre une décharge électrostatique.

2. Boîtier selon la revendication 1, dans lequel des moyens de rayonnement thermique (30) sont prévus sur ledit élément formant couvercle dissipateur de chaleur (14).

3. Boîtier selon la revendication 1, comprenant, en outre, au moins un second rembourrage élastique en matériau conducteur de chaleur (52) interposé entre une surface supérieure interne (54) dudit élément formant couvercle (14) et ledit dispositif électrique (24).

4. Boîtier selon la revendication 1, dans lequel ladite couche isolante de matériau (32) est disposée sur la totalité de la surface extérieure dudit élément formant couvercle dissipateur de chaleur (14).
